# EUROPEAN PATENT APPLICATION

(11) **EP 1 681 712 A1**
(43) Date of publication of application: **19.07.2006**
(21) Application number: 05290082.6
(22) Date of filing: 13.01.2005
(51) Int. Cl.: H01L 21/20, H01L 33/00

(54) **Method of producing substrates for optoelectronic applications**

(71) Applicant: S.O.I. Tec Silicon on Insulator Technologies S.A., 38190 Bernin (FR)
(72) Inventor: Letertre, Fabrice, 38000 Grenoble (FR); Faure, Bruce, 38000 Grenoble (FR)
(74) Representative: Grünecker, Kinkeldey, Stockmair & Schwanhäusser Anwaltssozietät

(57) **Abstract**

The present invention relates to a method of producing a substrate for an optoelectronic application, the substrate having at least one active nitride layer on a final carrier and a metallic intermediate layer therebetween, wherein the method comprises: preparation of an auxiliary substrate wherein one semi-conducting nitride layer is placed on an auxiliary carrier; metallising the auxiliary substrate on the side of the nitride layer; bonding of the metallised carrier substrate with the final carrier; and removing of the auxiliary carrier after the bonding step. It is the object of the present invention to provide a method of this type in which the crystalline quality of the active nitride layer(s) can be improved. The object is solved by a method of the above mentioned type wherein the step of preparing the auxiliary substrate comprises: detaching a part from a massive semi-conducting nitride substrate; and transferring said part onto the auxiliary carrier to form the semi-conducting nitride layer thereon.

## Description

The present invention relates to a method of producing a substrate for an optoelectronic application, the substrate having at least one active nitride layer on a final carrier and a metallic intermediate layer therebetween, wherein the method comprises: preparing of an auxiliary substrate wherein one semi-conducting nitride layer is placed on an auxiliary carrier; metallising the auxiliary substrate on the side of the nitride layer; bonding of the metallised carrier substrate with the final carrier; and removing of the auxiliary carrier after the bonding step.

In the field of optical applications, GaN based light emitting devices including light emitting diodes (LEDs) and laser diodes attracted great attention in recent years. Because these devices are capable of the generation of short wavelength emissions in UV and blue regions that can have many practical applications such as high density storage, high speed data processing, solid state lighting, flat panel colour display, and quantum computing. However, the realisation of GaN based layers is relatively recent in comparison to GaAs based layers. Therefore, the technology of GaN based layers is still in the development stage, and many technical issues remain to be addressed and resolved before those applications can be realised.

Considering the state of the art, it is known to produce GaN-on-sapphire templates for blue LED mass production. In a first step of a conventional approach, a GaN nucleation layer is grown on a sapphire substrate. In a second step, a two to four microns thick GaN buffer layer is grown on the nucleation layer. This growth step is very time-consuming and takes typically from two to four hours. In a last step, an InGaN/AlGaN/GaN-LED structure including cladding layers, multiple quantum valves and p-type layers with a total thickness of the LED structure of about 1 µm is grown on the GaN buffer layer.

Despite the fact that with this known technology a high device yield can be achieved, the resulting structures have some disadvantages. While the sapphire substrate is less expensive, and a more popular choice than a high cost GaN-substrate, it is non-conductive, requiring two wire bonds on top of each chip. With the electrical current travelling laterally between these two contacts the packaging efficiency is greatly reduced. While sapphire is transparent, enabling more light to escape from the chip, it unfortunately acts as a thermal insulator that traps heat, dramatically reducing the high operating current efficiency and ultimately limiting the available applications.

Furthermore, due to the lattice mismatch and temperature expansion co-efficient difference between sapphire and GaN, the GaN device structures grown on a sapphire substrate are known to have many defects that tend to effect the device performance. Other factors such as the insulating property and non-cleavage of sapphire material make manufacture of a GaN light emitting device with the conventional technology difficult.

Instead of sapphire substrates, SiC substrates can be used to grow thereon a GaN-layer. However, although conductive, SiC traps a substantial portion of the light being emitted since massive absorption occurs only in the UV range.

Therefore, in another known approach for producing vertical GaN-LEDs, under consideration of the above mentioned advantages and disadvantages of sapphire and SiC substrates, a sapphire substrate is used as the initial GaN growth substrate followed by bonding a thermally and electrically conductive metal layer on top of the GaN. By then employing an appropriate lift-off technique, the sapphire substrate is lifted off the GaN, leaving it and the reflective base ready for the fabrication of vertical devices.

The result of a vertical device being bonded to a reflective metal layer that exhibits low thermal resistance, and high electrical conductivity, leads to efficient devices that lend themselves to thinner LED packaging while remaining rugged enough to retain comfortability with traditional die-mount techniques. Due to a high brightness, this approach is especially advantageous for back light applications such as cellular phones, where a thinner die saves precious space, as well as for high power / super bright applications such as solid state white lighting.

Nevertheless, even this approach cannot prevent the disadvantages leading from the difference of material properties between the sapphire substrate and the GaN-layer grown thereon. In particular, the dislocation density of the active nitride layer(s) of such substrates which is usually in the order of 10⁸/cm² strongly restrains the efficiency of optical devices fabricated with such substrates.

It is therefore the object of the present invention to provide a method of the above mentioned type in which the crystalline quality of the active nitride layer(s) can be improved.

The object is solved by a method of the above mentioned type wherein the step of preparing the auxiliary substrate comprises: detaching a part from a massive semi-conducting nitride substrate; and transferring said part onto the auxiliary carrier to form the semi-conducting nitride layer thereon.

With the inventive method, substrates for optoelectronic applications having active layer(s) with a low density of crystalline defects can be fabricated. In particular, the dislocation density of the active layer(s) can be brought to below 10⁸/cm² although the active layer(s) can be made with a low thickness. This has the effect that optoelectronic devices fabricated by using these substrates can achieve a high efficiency and lifetime at low dimensions and weight.

Furthermore, the intermediate metal layer can assure good electrical conduction between the active nitride layer(s) and the carrier substrate and can serve an additional purpose as a thermal drain between the active layer(s) and the carrier substrate. This way, the final substrate can be well electrically contacted and the thermal stress during operation can be kept to a low value.

According to a beneficial embodiment of the present invention, the semi-conducting nitride substrate is a GaN-substrate or an AIN substrate. GaN and AIN have the advantage that the growth of these materials as well as their properties are relatively well known so that these materials can be provided with a high crystal quality.

In a favourable example of the present invention, the massive semi-conducting nitride substrate is produced with a dislocation density of less than 10⁶/cm². Because of the very low dislocation density of the semi-conducting nitride substrate from which the semi-conducting nitride layer is detached, the nitride layer formed on the auxiliary carrier has also a very low dislocation density resulting in a low dislocation density of layer(s) grown subsequently on the transferred semi-conducting nitride layer. With this method, the active part of the resulting substrate has a very good crystallinity independent from the properties of the final carrier.

In a favourable example of the present invention, the step of detaching and transferring comprises: depositing of a dielectric layer on the semi-conducting nitride substrate; implanting species through the dielectric layer into a certain depth of the nitride substrate to form therein a predetermined splitting area; bonding of the nitride substrate on the implanted side with the auxiliary carrier; and thermal and/or mechanical treating of the nitride substrate to split said substrate along the predetermined splitting area. These steps are taken from the known Smart Cut™ technology and lead to a smooth and highly accurate transfer of a high quality nitride layer with a defined thickness onto the auxiliary carrier.

In an advantageous embodiment of the present invention, the auxiliary carrier is a substrate selected from a group of materials comprising silicon, GaAs and ZnO. These substrates can provide a high mechanical strength which is explicitly favourable during the step of detaching and transferring in which the auxiliary carrier is under relatively high mechanical stress. Furthermore, the coefficient of thermal dilatation of GaAs and ZnO is slightly higher than the coefficient of thermal dilatation of typical semi-conducting nitride layers such as GaN or AIN, resulting in an active layer of the final substrate having only slight compression which prevents occurrence of cracking effects in the active layer.

According to another beneficial variant of the present invention, the auxiliary substrate is annealed after the detaching and transferring step. The annealing step reinforces connection at the interface between the transferred nitride layer and the auxiliary carrier.

In a further example of the present invention, a protective layer is brought onto the transferred nitride layer before the annealing step and is removed thereafter. This way, the transferred nitride layer can be protected from chemical influences in the annealing environment which could otherwise lead to chemical reaction(s) with the nitride layer or to other unintentional changes of crystallinity or purity of the nitride layer.

In another preferred embodiment of the present invention, the surface of the transferred nitride layer is smoothed after the detaching and transferring step or after the annealing step. The removal of a certain degree of roughness of the transferred nitride layer surface is favourable for its utilisation as a basis for subsequent layers which can be better deposited on a smooth subsurface. This smoothing step can be implemented before or after the annealing step.

It is furthermore advantageous to deposit at least one epitaxial nitride layer of a material of a group comprising N-doped GaN, InGaN, AlGaN, undoped GaN and P-doped GaN on the transferred nitride layer of the auxiliary substrate. The additional epitaxial layer(s) are well suited to form the active layer(s) of an optoelectronic structure.

In a further favourable embodiment of the present invention, the metallic intermediate layer is deposited on the at least one epitaxial nitride layer. This way, the metallic intermediate layer can form an Ohmic contact for the at least one epitaxial nitride layer. Depending on the metal species chosen to form the intermediate layer, it could be useful to apply an annealing step in order to create an alloy between the nitride material and the metals used. This allows to shift from a Schottky contact behaviour to an Ohmic contact behaviour.

In another example of the present invention, the method further comprises providing a final carrier and bonding of said final carrier on the metallised side of the auxiliary substrate. The final carrier provides a good mechanical support for the transferred nitride layer and the deposited at least one epitaxial layer from the side opposite to the auxiliary carrier.

In a beneficial variant of the present invention, the material of the final carrier is selected from a group comprising silicon, silicon carbide and copper. These materials provide good electrical and thermal conductivity which is particularly relevant for a later optoelectronic application of the produced substrate wherein the electrical conductivity can be used to form an Ohmic contact on the final carrier and the thermal conductivity serves to provide a good thermal drainage for an optoelectronic device with the final carrier.

In a yet further advantageous embodiment of the present invention, at least one reflection layer is deposited onto the final carrier before the bonding step of the final carrier with the auxiliary substrate. The reflection layer serves as a mirror between the active layer(s) and the final carrier so that the light emitted from the active layer(s) will not be absorbed by the final carrier.

According to another convenient embodiment of the present invention, the auxiliary carrier is removed mechanically and/or chemically after the bonding step, wherein the nitride layer is used as a stop layer for the removal step. In this step, the active layer(s) of the final substrate can be excavated.

In yet another advantageous example of the present invention, the transferred nitride layer is removed from the substrate after the removal step of the auxiliary carrier. The removal of non-essential layer(s), such as the transferred nitride layer, improves the efficiency of the whole structure since inutile layer(s) would lead to an unwanted absorption of photons emitted from the active layer(s).

Further advantageous objects of the present invention will become more apparent with the following detailed description when taken with reference to the accompanying drawings in which:
Figure 1 schematically shows a step of providing a massive semi-conductive nitride substrate according to an embodiment of the present invention;
Figure 2 schematically shows a deposition step of a dielectric layer on the substrate of Figure 1;
Figure 3 schematically shows an implantation step in the structure of Figure 2;
Figure 4 schematically shows a bonding step of the structure of Figure 3 with an auxiliary carrier;
Figure 5 schematically shows a splitting step of the structure of Figure 4;
Figure 6 schematically shows a polishing step of a split structure of Figure 5;
Figure 7 schematically shows a deposition step of a protective layer on the structure of Figure 6;
Figure 8 schematically shows an annealing step of the structure of Figure 7;
Figure 9 schematically shows a removal step of the protective layer of the structure of Figure 7 after the annealing step of Figure 8;
Figure 10 schematically shows a growth step of an epitaxial layer on the structure of Figure 9;
Figure 11 schematically shows a deposition step of a metal layer on the structure of Figure 10;
Figure 12 schematically shows a final carrier with a reflection layer;
Figure 13 schematically shows a bonding step between the structures of Figure 11 and 12;
Figure 14 schematically shows the structure of Figure 13 after a removal step of the auxiliary carrier and the dielectric layer;
Figure 15 schematically shows the structure of Figure 14 after the removal of a semi-conducting nitride layer; and
Figure 16 schematically shows a preparation of an electrical contact on the structure of Figure 15.

It should be noted that the dimensions shown in the Figures are not true to scale.

While the present invention is described with reference to the embodiments as illustrated in the following detailed description as well as in the drawings, it should be understood that the following detailed description as well as the drawings are not intended to limit the present invention to the particular illustrative embodiments disclosed, but rather to describe the illustrative embodiments merely exemplifying the various aspects of the present invention, the scope of which is defined by the appended claims.

According to the present invention, an efficient method of producing substrates for optoelectronic applications is provided which may be used to fabricate optoelectronic devices such as LED structures or laser diodes.

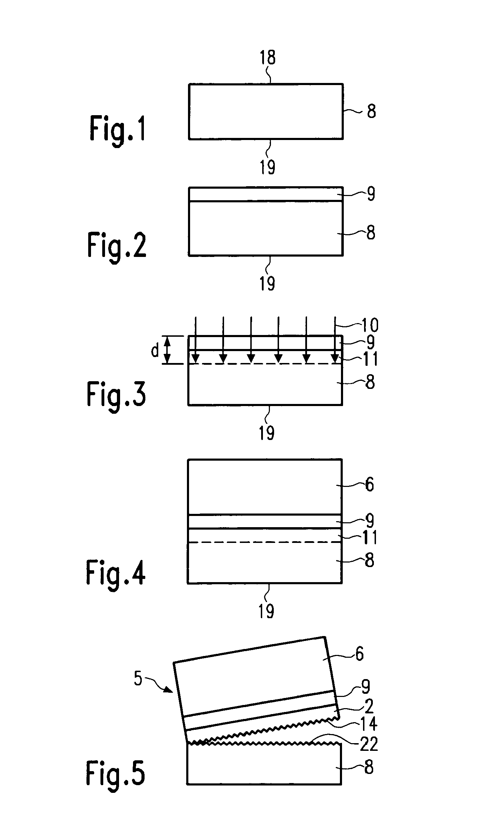

The Figures 1 to 16 show an illustrative process flow of an embodiment of the present invention.

With reference to Figure 1, a step of providing a massive semi-conducting nitride substrate is shown. In the embodiment shown, the massive semi-conducting nitride substrate is a GaN-substrate 8 having a nitrogen face 18 on top and on its bottom a gallium face 19. The massive GaN-substrate has a hexagonal crystal structure with a dislocation density of lower than 10⁶/cm². The planarity of the substrate 8 is in the range of 20 µm. The nitride substrate 8 has a thickness of about 150 to 750 µm. The nitrogen face 18 of the nitride substrate 8 is polished and has a surface roughness of lower than 0.3 nm RMS measured with an atomic force microscope (AFM) over a field of some 1x1 µm².

The above described technology can also be realised using a semi-conducting nitride substrate of GaN with a cubic crystal structure or with a cubic or hexagonal monocrystalline AIN substrate instead of the hexagonal GaN-substrate 8. In all of these cases, the dislocation density of the substrate 8 should be between 10⁵ to 10⁶/cm² or even lower.

Figure 2 schematically shows a deposition step of a dielectric layer 9 on the massive semi-conducting nitride substrate 8. This deposition step is performed on the nitrogen face 18 of the nitride substrate 8. The dielectric layer 9 can be a material selected from a group comprising silicon dioxide, silicon nitride, a combination of these materials or other dielectric materials which have a good adhesion to the nitrogen face 18 of the GaN-substrate 8. The dielectric layer(s) 9 are favourably deposited by chemical vapour deposition. Although not absolutely necessary, the structure shown in Figure 2 can be thermally annealed to densify the dielectric layer(s) 9.

As illustrated in Figure 3, the structure shown in Figure 2 is implanted with species 10 in an implantation step. The species 10 can be of hydrogen, helium or other elements alone or in combination. In the embodiment shown, the species 10 are implanted with energies between 20 and 200 keV and with doses between 10¹⁵ and 10¹⁸ at/cm². The species 10 are implanted in a certain depth d of the nitride substrate 8 forming there a predetermined splitting area 11, at and around the implantation depth d.

According to Figure 4, the implanted structure of Figure 3 is bonded on its implanted side with an auxiliary carrier 6. The auxiliary carrier 6 is preferably a silicon substrate, GaAs substrate or a ZnO substrate but can also be of another material which has relatively high mechanical stability since this material will be highly stressed during a following Smart Cut™ process in which the nitride substrate 8 is split. In the case of GaAs or ZnO as auxiliary substrate 6, the thermal dilatation coefficient of the auxiliary carrier 6 is chosen or adapted in such a way that it is slowly higher than the thermal dilatation coefficient of GaN, resulting in a structure having a GaN-layer with a slight compression preventing an appearance of cracking in this layer.

As shown in Figure 5, the structure of Figure 4 is split into two parts with thermal and/or mechanical treatment. The stress applied due to that treatment leads to the splitting of the structure of Figure 4 along the predetermined splitting area 11. The splitting step results in two structures, a residual part of the former semi-conductive nitride substrate 8 and an auxiliary substrate 5 consisting of the auxiliary carrier 6, the dielectric layer 9 and a semi-conducting nitride layer 2 being a part of the former semi-conducting nitride substrate 8. The split structures have split surfaces 14 and 22 with an increased roughness after the splitting step.

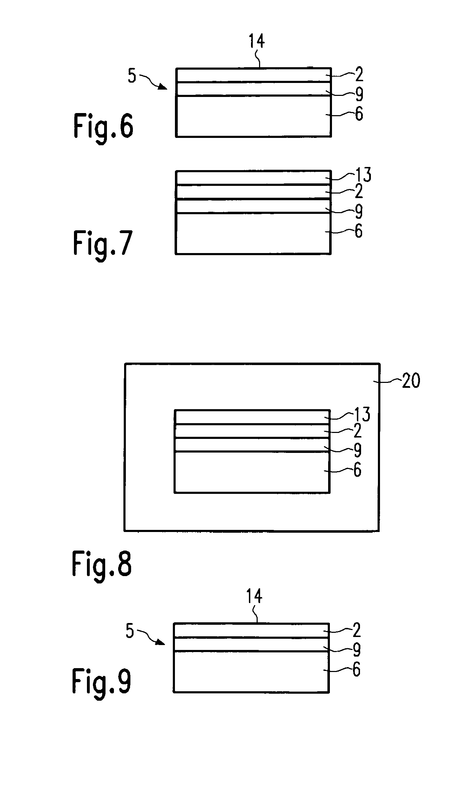

With reference to Figure 6, the auxiliary substrate 5 is smoothed in a polishing step applied on the split surface 14 of the nitride layer 2. After this polishing step, the surface roughness of the GaN-layer 2 is of an atomic level which is only several Angstroms when measured with an AFM.

In the next step, shown in Figure 7, a protective layer 13 is deposited on the surface 14 of the GaN-layer 2. The protective layer 13 is preferably a dielectric layer.

As shown in Figure 8, the structure of Figure 7 is thermally annealed in an annealing equipment 20. The structure is thermally treated in a temperature region between 500 and 1100 °C in a gaseous atmosphere which permits preservation of the crystal quality of the GaN-layer 2. The annealing step shown in Figure 8 can also be applied before the polishing step shown in Figure 6 and can also be applied directly onto the auxiliary substrate 5 without the deposition of the protective layer 13 before the annealing step. The thermal annealing step leads to an enforcement of the bonding forces at the interface between the auxiliary carrier 6 and the dielectric layer 9.

As shown in Figure 9, the protective layer 13 which can be deposited before the annealing step shown in Figure 8, is removed in a removal step. In a favourable example of the invention, the protective layer 13 can be removed with a chemical treatment, for instance with HF. The removal step results in the auxiliary substrate 5 having a smooth and clean gallium face 14 on top of the GaN-layer 2. The GaN-layer 2 is monocrystalline with a crystal quality equivalent to the crystal quality of the massive semi-conducting nitride substrate 8 as shown in Figure 1. The surface of the GaN-layer 2 is nearly free from particles. The thickness of the GaN-layer 2 is, in one favourable example of the invention, about 200nm.

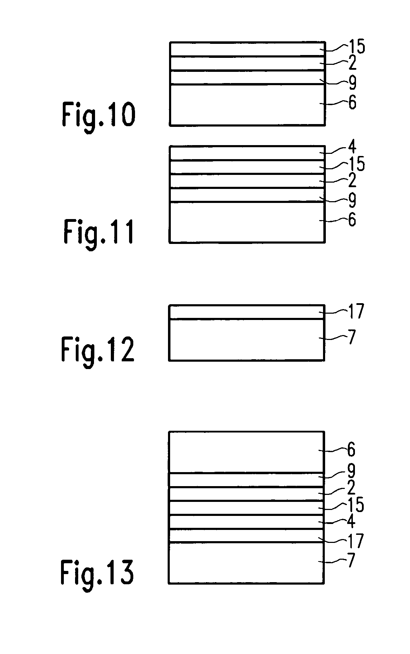

With reference to Figure 10, in a further step an epitaxial layer 15 is deposited on the gallium face 14 of the GaN-layer 2. The epitaxial layer 15 can be deposited with a known epitaxy method like MOCVD, MBE or HVPE. The temperature applied during the epitaxial deposition step is in the range between 700 and 1100°C.

For example, the epitaxial layer(s) deposited in the step shown in Figure 10 can be: of n-type GaN doped with Si and having a thickness of about 0.2 µm, of InGaN, of AlGaN and/or of p-type GaN doped with Mg. The total thickness of the epitaxial layer(s) 15 is, in a favourable example of the invention, about 0.5 µm. The composition of the epitaxial layer(s) depends on the efficiency and the wavelength of the optoelectronic structure which shall be fabricated with the resulting substrate. The dislocation density of the epitaxial layer(s) 15 is nearly equivalent to the dislocation density of the original GaN-substrate 8, that means lower than 10⁶/cm². It is generally advantageous to have epitaxial layer(s) with an increased thickness to advance current propagation in the active layer(s) of the resulting structure.

In a next step, shown in Figure 11, a metal layer 4 is deposited on the epitaxial layer(s) 15. The metal layer 4 serves later as an Ohmic contact to contact the resulting structure electrically. The metal layer 4 can be of Ni/Au, Pt, rhodium or another conductive material.

With reference to Figure 12, a final carrier 7 is provided on which a reflection layer 17 is deposited. The final carrier 7 serves as a support substrate which is electrically conductive with a low electrical resistivity and a good thermal conductivity. The final carrier 7 can be of silicon, SiC, copper or another conductive or semi-conducting material. The reflection layer 17 can be for instance of gold, aluminium or silver which materials have good reflectivity. The reflection layer 17 acts later as a mirror layer arranged between the final carrier 7 and the epitaxial layer(s) 15. Said mirror is chosen depending on the emitted wavelength(s) of the resulting structure.

As illustrated in Figure 13, the structures of Figures 11 and 12 are connected on the metal layer 4 and the reflection layer 17 in a bonding step. The bonding step leads to a molecular adhesion between the structures of Figures 11 and 12 to provide a contact therebetween using mechanical pressure and a certain temperature.

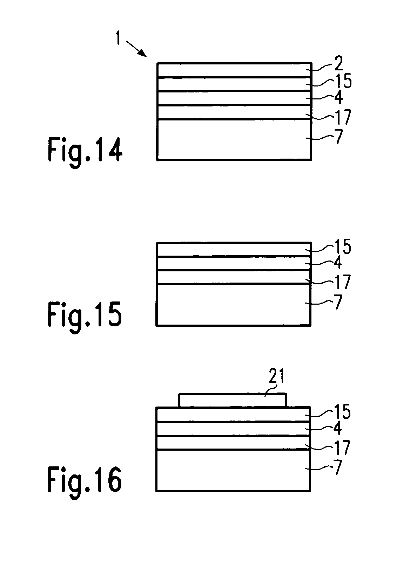

As shown in Figure 14, in a further step the auxiliary carrier 6 and the dielectric layer 9 are removed from the bonded structure in a removal step. The removal step can comprise mechanical lapping and/or polishing as well as a chemical attack using the gallium nitride layer 2 as an etch stop layer. If the final carrier 7 is of silicon, the removal can be realised using mechanical treatment followed by chemical treatment based on a TMAH or HF/HNO3 solution. Said chemical attack can be realised by immersing the structure in a bath of said solution using an equipment with which the structure can be held in rotation and in which the auxiliary carrier can be exposed to the chemical solution. The removal of the auxiliary carrier can also be realised by using only chemical treatment.

In a next step shown in Figure 15, the gallium nitride layer 2 is removed from the structure shown in Figure 14. A removal of inutile layers, such as the non-doped GaN-layer 2 can result in an enhancement of efficiency of the resulting structure since such layers would only lead to an unfortunate absorption of photons. GaN absorbs, for instance, UV radiation.

With reference to Figure 16, an electrical contact 21 is provided on the epitaxial layer(s) 15.

The resulting structure consists of the final carrier 7, the reflection layer 17, the metal layer 4, the epitaxial layer(s) 15 and the electrical contact 21. The metal layer 4 and the reflection layer 17 form together a metallic junction or metallic intermediate layer between the carrier substrate 7 and the epitaxial layer(s) 15. The metallic intermediate layer can include or not include the reflection layer 17.

In following steps which are not shown, the structure shown in Figure 16 is further processed by using lithographic and etch steps for chip fabrication, deposition steps of dielectric layers for preservation of the structure and deposition steps of metal layers to realise contacts on both sides of the structure. As last steps, the fabricated structures are separated into chips which are packaged finally.

With the inventive method, a substrate with an active layer of very good crystal quality and with eliminated inutile layers can be realised for optoelectronic applications. The good crystal quality is very important for a high efficiency and long life span of the structures, in particular for LED structures of laser diodes. Furthermore, due to the elimination of GaN inutile layers in the inventive method allows minimisation of photon absorption in the active layer(s) resulting in a high efficiency of light radiation.
The inventive technology uses the very good crystallinity of the massive nitride substrate in a direct transfer of a part of said substrate to the final substrate. This way, the final active epitaxial layer(s) can be grown directly on the high quality transferred part with the same good crystallinity leading to high quality final structures.

## Claims

1. A method of producing a substrate (1) for an optoelectronic application, the substrate (1) having at least one active nitride layer (2, 15) on a final carrier (7) and a metallic intermediate layer (4) therebetween, wherein the method comprises: preparing of an auxiliary substrate (5) wherein one semi-conducting nitride layer (2) is placed on an auxiliary carrier (6);
metallising the auxiliary substrate (5) on the side of the nitride layer (2);
bonding of the metallised auxiliary substrate (5) with the final carrier (7); and
removing of the auxiliary carrier (6) after the bonding step
**characterised in that**
the step of preparing the auxiliary substrate (5) comprises:
detaching of a part from a massive semi-conducting nitride substrate (8); and
transferring said part onto the auxiliary carrier (6) to form thereon the semi-conducting nitride layer (2).

2. The method of claim 1, **characterised in that** the semi-conducting nitride substrate (8) is a GaN-substrate or an AlN substrate.

3. The method of one of the claims 1 or 2, **characterised in that** the massive semi-conducting nitride substrate (8) is produced with a dislocation density of less than 10^6/cm².

4. The method of one of the preceding claims, **characterised in that** the step of detaching and transferring comprises:
depositing of a dielectric layer (9) on the semi-conducting nitride substrate (8); implanting species (10) through the dielectric layer (9) into a certain depth (d) of the nitride substrate (8) to form therein a predetermined splitting area (11);
bonding of the nitride substrate (8) on the implanted side (12) with the auxiliary carrier (6); and
thermal and/or mechanical treating of the nitride substrate (8) to split said substrate (8) along the predetermined splitting area (11).

5. The method of one of the preceding claims, **characterised in that** the auxiliary carrier (6) is a substrate selected from a group of materials comprising silicon, GaAs and ZnO.

6. The method of one of the preceding claims, **characterised in that** the auxiliary substrate (5) is annealed after the detaching and transferring step.

7. The method of claim 6, **characterised in that** a protective layer (13) is deposited onto the transferred nitride layer (2) before the annealing step and is removed after the annealing step.

8. The method of one of the preceding claims, **characterised in that** the surface (14) of the transferred nitride layer (2) is smoothed after the detaching and transferring step or after the annealing step.

9. The method of one of the preceding claims, **characterised in that** at least one epitaxial nitride layer (15) of a material of a group comprising n-type GaN, InGaN, AlGaN, undoped GaN and p-type GaN is deposited on the transferred nitride layer (2) of the auxiliary substrate (5).

10. The method of claim 9, **characterised in that** the metallic intermediate layer (4) is deposited on the at least one epitaxial nitride layer (15).

11. The method of claim 10, **characterised in that** the method further comprises providing the final carrier (7) and bonding of said final carrier (7) on the metallised side (16) of the auxiliary substrate (5).

12. The method of claim 11, **characterised in that** the material of the final carrier (7) is selected from a group comprising silicon, silicon carbide and copper.

13. The method of one of the claims 11 or 12, **characterised in that** at least one reflection layer (17) is deposited onto the final carrier (7) before the bonding step of the final carrier (7) with the auxiliary substrate (5).

14. The method of one of the claims 11 to 13, **characterised in that** the auxiliary carrier (6) is mechanically and/or chemically removed after the bonding step, wherein the nitride layer (2) is used as a stop layer for the removal step.

15. The method of claim 14, **characterised therein that** the transferred nitride layer (2) is removed from the substrate (1) after the removal step of the auxiliary carrier (6).

## Amended claims

### Amended claims in accordance with Rule 86(2) EPC.

**1.** A method of producing a substrate (1) for an optoelectronic application, the substrate (1) having at least one active nitride layer (2, 15) on a final carrier (7) and a metallic intermediate layer (4) therebetween, wherein the method comprises:
preparing of an auxiliary substrate (5) wherein one semiconducting nitride layer (2) is placed on an auxiliary carrier (6);
metallizing the auxiliary substrate (5) on the side of the nitride layer (2);
bonding of the metallized auxiliary substrate (5) with the final carrier (7); and
removing of the auxiliary carrier (6) after the bonding step
**characterized in that**
the step of preparing the auxiliary substrate (5) comprises:
bonding the auxiliary carrier (6) with a massive semiconducting nitride substrate (8) having a nitrogen face (18), on the side of the nitrogen face (18) of the nitride substrate (8); and
detaching a part from the massive semiconducting substrate (8) to form the semiconducting nitride layer (2) on the auxiliary carrier (6).
